# EUROPEAN PATENT APPLICATION

(11) **EP 3 089 566 A1**
(43) Date of publication of application: **02.11.2016**
(21) Application number: 14874338.8
(22) Date of filing: 09.12.2014
(51) Int. Cl.: H05K 1/18, H01C 7/04, H01L 21/60

(54) **ELECTRONIC COMPONENT**

(30) Priority: 26.12.2013 JP 2013269562
(71) Applicant: Kabushiki Kaisha Toyota Jidoshokki, Kariya-shi, Aichi 448-8671 (JP)
(72) Inventor: OZAKI, Kiminori, Kariya-shi Aichi 448-8671 (JP)
(74) Representative: TBK
(86) International application number: PCT/JP2014/082574
(87) International publication number: WO 2015/098503

(57) **Abstract**

An electronic component has a main body and an electrode that is provided on the main body and configured to be joined to a circuit board with a conductor. The main body includes a connecting portion, which is configured to be connected to a connecting member, a fitting portion that is allowed to be fitted to a receiving portion provided in the circuit board, and a contacting portion, which is allowed to contact a surface of the circuit board.

## Description

### TECHNICAL FIELD

The present invention relates to an electronic component that is to be joined to a circuit board and is to be connected to a connecting member.

### BACKGROUND ART

Conventionally, reflow soldering as disclosed in Patent Document 1 has been known as a method for joining an electronic component mounted on a circuit board to the circuit board.

### PRIOR ART DOCUMENTS

### Patent Documents

Patent Document 1: Japanese Laid-Open Patent Publication No. 11-233910

### SUMMARY OF THE INVENTION

### Problems that the Invention is to Solve

In some cases, an electronic component that has been joined to a circuit board by reflow soldering is desired to be connected to another connecting member. In a reflow soldering process, the surface tension of the solder moves the entire electronic component relative to the circuit board, so that the position of the connecting portion of the electronic component to be connected to the connecting member is also moved relative to the circuit board. When the circuit board, on which the electronic component is mounted, is arranged at a predetermined position in relation to the connecting member, the position of the connecting portion can be displaced in relation to the position of the connecting member. In such a case, the connecting portion of the electronic component and the connecting portion may fail in being connected to each other.

Even in cases in which an electronic component is joined to a circuit board by means other than reflow soldering, it is preferable that the position of the connecting portion of the electronic component remain unmoved relative to the circuit board.

Accordingly, it is an objective of the present invention to provide an electronic component that restrains the position of a connecting portion of the electronic component from being displaced in relation to a connection section of a connecting member when a circuit board, on which the electronic component is mounted, is arranged at a predetermined position in relation to the connecting member.

### Means for Solving the Problems

To achieve the foregoing objective and in accordance with one aspect of the present invention, an electronic component is provided that includes a main body and an electrode, which is provided on the main body and is configured to be joined to a circuit board with a conductor. The main body includes a connecting portion, which is configured to be connected to a connecting member, a fitting portion, which is allowed to be fitted to a receiving portion provided in the circuit board, and a contacting portion, which is allowed to contact a surface of the circuit board.

### BRIEF DESCRIPTION OF THE DRAWINGS

Fig. 1 is a top view of an electronic component according to one embodiment mounted on a circuit board.
Fig. 2 is a perspective view of the electronic component.
Fig. 3 is a top view of the electronic component.
Fig. 4 is a side view of the electronic component.
Fig. 5 is a bottom view of the electronic component when positioned in relation to the circuit board.

### MODES FOR CARRYING OUT THE INVENTION

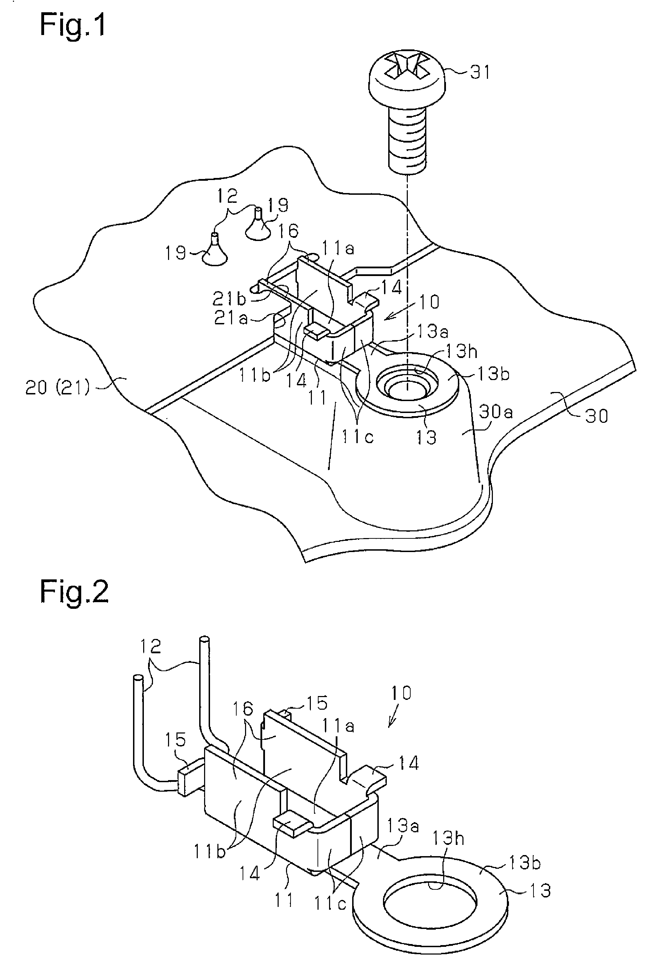

An electronic component according to one embodiment will now be described with reference to Figs. 1 to 5.

As shown in Fig. 1, an electronic component 10 is joined to a circuit board 20 by reflow soldering with solder 19, which functions as a conductor, to be mounted on the circuit board 20. The circuit board 20, on which the electronic component 10 is mounted, is arranged at a predetermined position in relation to a plate-shaped heat dissipater 30, which is a connecting member different from the circuit board 20.

The heat dissipater 30 is made of metal such as aluminum. The heat dissipater 30 has in it a fluid passage (not shown), through which fluid, for example, water, flows as a cooling medium. The heat dissipater 30 draws heat transferred from a part such as the circuit board 20 to the heat dissipater 30 with the fluid passing through the fluid passage.

The electronic component 10 includes a main body 11, a pair of electrodes 12, and a connecting portion 13. The electrodes 12 are provided on the main body 11 and joined to the circuit board 20 by reflow soldering. The connecting portion 13 is provided on the main body 11 and connected to a boss portion 30a of the heat dissipater 30. The connecting portion 13 is fastened to the boss portion 30a with a bolt 31. In the present embodiment, the electronic component 10 is a thermistor (a water temperature sensor), which is used to measure the temperature of the heat dissipater 30, specifically, the temperature of the fluid passing through the fluid passage.

As shown in Fig. 2, the main body 11 includes a bottom plate portion 11 a, which is rectangular in a plan view, and two long side plate portions 11 b, which extend from the two long sides of the bottom plate portion 11 a. Each long side plate portion 11 b is shaped as a flat plate that extends in a direction perpendicular to the bottom plate portion 11 a. The two long side plate portions 11 b extend in parallel. The main body 11 further includes two short side plate portions 11c, which correspond to the long side plate portions 11 b. The two short side plate portions 11c extend toward each other from edges of the long side plate portions 11 b on one side in the longitudinal direction. Each short side plate portion 11c is shaped as a flat plate that extends in a direction perpendicular to the corresponding long side plate portion 11 b.

Each electrode 12 is shaped like a rod. The electrodes 12 extend in the longitudinal direction of the bottom plate portion 11a from the edge of the bottom plate portion 11a on the side opposite from the short side plate portions 11c. The electrodes 12 are then bent to extend in the direction in which the long side plate portions 11 b project. The direction in which the electrodes 12 protrude is the same as the longitudinal direction of the bottom plate portion 11a.

The connecting portion 13 includes a flat plate-shaped extension 13a and an annular insertion portion 13b. The extension 13a is integral with the bottom plate portion 11a. The extension 13a linearly extends from the edge of the bottom plate portion 11a at which the short side plate portions 11c are located. The insertion portion 13b is located at the distal end of the extension 13a. The insertion portion 13b has a through-hole 13h, in which the bolt 31 is allowed to be inserted.

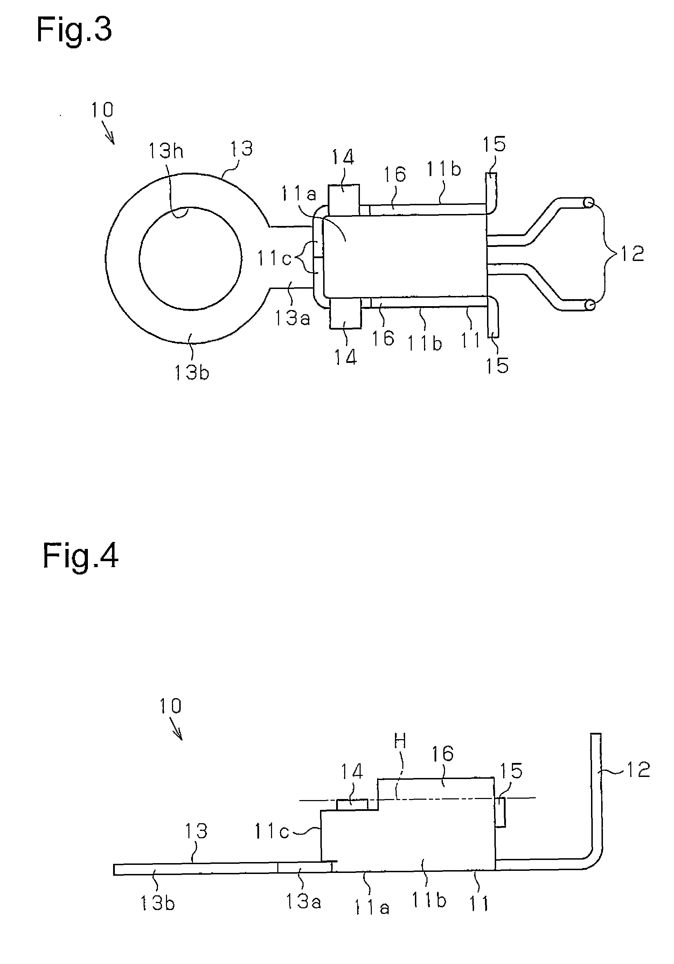

As shown in Fig. 3, the long side plate portions 11 b have flat plate-shaped first lugs 14, which are provided on the edges opposite from the bottom plate portion 11 a and at positions closer to the short side plate portions 11c. The flat plate-shaped first lugs 14 protrude outward away from each other. Also, the long side plate portions 11 b also have flat plate-shaped second lugs 15, which are provided on the edges opposite from the short side plate portions 11c. The flat plate-shaped second lugs 15 protrude outward away from each other. The first lugs 14 and the second lugs 15 protrude in directions perpendicular to the direction in which the electrodes 12 protrude.

As shown in Fig. 4, the end faces of the first lugs 14 on the side opposite from the bottom plate portion 11a and the end faces of the second lugs 15 on the side opposite from the bottom plate portion 11a are located on a common plane, which is an imaginary plane H extending in parallel with the bottom plate portion 11a. The long side plate portions 11 b have protrusions 16, which are provided on the side opposite from the bottom plate portion 11a and between the first lugs 14 and the second lugs 15. The protrusions 16 protrude beyond the imaginary plane H in a direction opposite from the bottom plate portion 11a.

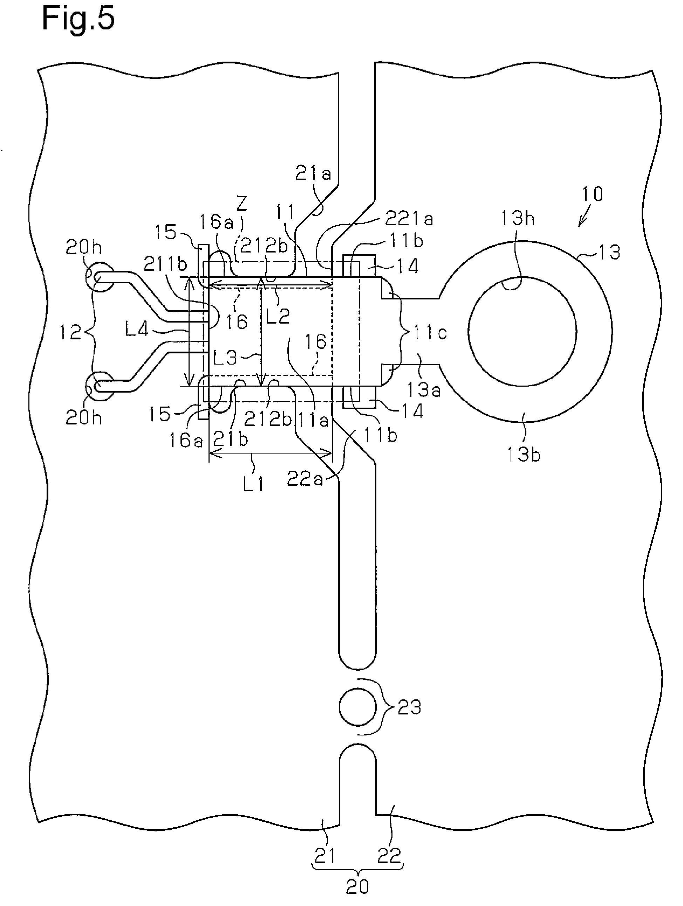

As shown in Fig. 5, the circuit board 20 includes a first circuit board 21 and a second circuit board 22. The first circuit board 21 has two insertion holes 20h, in which the electrodes 12 are allowed to be inserted. The second circuit board 22 is arranged side by side with the first circuit board 21 in a planar direction. The diameter of the insertion holes 20h is set greater than the outer diameter of the electrodes 12. The first circuit board 21 and the second circuit board 22 are coupled to each other at parts of the opposed outer edges by coupling portions 23. The first circuit board 21 has a recess 21 a, which is recessed in a trapezoidal shape from the outer edge. Further, the first circuit board 21 has a cutout portion 21 b, which is continuous with the recess 21 a and has a substantially rectangular shape in a plan view.

The second circuit board 22 has a trapezoidal protuberance 22a, which protrudes toward the recess 21 a of the first circuit board 21. The protuberance 22a has a distal end 221 a, and the cutout portion 21 b has an inner bottom portion 211b, which is opposed to the distal end 221 a. The distance L1 between the distal end 221 a and the inner bottom portion 211 b is equal to the length L2 of each protrusion 16 in the longitudinal direction (indicated by the broken lines in Fig. 5). The cutout portion 21 b has two opposed inner sides 212b. The distance L3 between the inner sides 212b is equal to the distance L4 between outer surfaces 16a of the protrusions 16. Thus, the protrusions 16 are configured to be fit between the cutout portion 21 b and the protuberance 22a. That is, in the present embodiment, the circuit board 20 has a receiving portion, which is constituted by the cutout portion 21 b and the protuberance 22a to receive the protrusions 16. The protrusions 16 constitute fitting portions, which are fitted to the receiving portion.

The first lugs 14 contact the back side of the protuberance 22a of the second circuit board 22, that is, the back side of the circuit board 20, which is one of the surfaces of the circuit board 20. The second lugs 15 contact the back side of the first circuit board 21 at a position on the opposite side of the inner bottom portion 211 b from the recess 21 a of the cutout portion 21 b, that is, the back side of the circuit board 20, which is one of the surfaces of the circuit board 20. Thus, the first lugs 14 and the second lugs 15 function as contacting portions, which are allowed to contact the back side of the circuit board 20. Therefore, in the present embodiment, the main body 11 has four contacting portions that are allowed to contact the back side of the circuit board 20.

The first lugs 14 and the second lugs 15 are arranged in relation to the main body 11 such that a region Z surrounded by the lugs 14, 15 (indicated by the long dashed double-short dashed line Fig. 5) contains a part of the main body 11. The region Z is a rectangular region in a plan view, which is surrounded by straight lines that connect substantially centers of parts of the first lugs 14 and the second lugs 15 that contact the back side of the circuit board 20.

Operation of the present embodiment will now be described. A process will also be described in which the electronic component 10 is mounted on the circuit board 20, and the connecting portion 13 is fastened to the boss portion 30a with the bolt 31.

First, the electronic component 10 is arranged on the back side of the circuit board 20 such that the protrusions 16 are fitted between the cutout portion 21 b and the protuberance 22a. At this time, each electrode 12 is inserted in the corresponding insertion hole 20h. Fitting the protrusions 16 between the cutout portion 21 b and the protuberance 22a causes the ends of the protrusions 16 in the vicinity of the first lugs 14 to contact the distal end 221 a of the protuberance 22a. The ends of the protrusions 16 that are close to the second lugs 15 contact the inner bottom portion 211 b of the cutout portion 21 b. Further, fitting the protrusions 16 between the cutout portion 21 b and the protuberance 22a causes the outer surfaces 16a of the protrusions 16 to contact the inner sides 212b of the cutout portion 21 b. Accordingly, the position of the circuit board 20 in the planar direction on the electronic component 10 is defined.

Also, the first lugs 14 contact the back side of the protuberance 22a of the second circuit board 22. The second lugs 15 contact the back side of the first circuit board 21 at a position on the opposite side of the inner bottom portion 211 b from the recess 21 a of the cutout portion 21 b. Accordingly, the position of the circuit board 20 in the thickness direction of the electronic component 10 is defined.

The end faces of the first lugs 14 that are on the opposite side from the bottom plate portion 11 a and the end faces of the second lugs 15 that are on the opposite side from the bottom plate portion 11 a are on the common plane. Thus, the positions at which the first lugs 14 and the second lugs 15 contact the back side of the circuit board 20 are located on the common plane. Further, the first lugs 14 and the second lugs 15 are arranged in relation to the main body 11 such that a region Z surrounded by the lugs 14, 15 contains a part of the main body 11. Thus, when the first lugs 14 and the second lugs 15 contact the back side of the circuit board 20, the imaginary plane H of the region Z is parallel with the back side of the circuit board 20. Therefore, the orientation of the electronic component 10 is prevented from being inclined with respect to the back side of the circuit board 20.

Then, joining the electrodes 12 to the circuit board 20 by reflow soldering mounts the electronic component 10 on the circuit board 20. At this time, the electronic component 10 is positioned in relation to the circuit board 20 by the protrusions 16 being fitted between the cutout portion 21 b and the protuberance 22a and the first lugs 14 and the second lugs 15 contacting the back side of the circuit board 20. The electrodes 12 are thus restrained from being moved by the surface tension of solder caused by reflow soldering. As a result, when the circuit board 20, on which the electronic component 10 is mounted, is arranged at a predetermined position in relation to the heat dissipater 30, the position of the connecting portion 13
is restrained from being displaced in relation to the boss portion 30a, to which the heat dissipater 30 is connected. The connecting portion 13 is fastened to the boss portion 30a with the bolt 31 after the second circuit board 22 is separated from the first circuit board 21 by cutting the coupling portions 23.

The above described embodiment provides the following advantages.
(1) The cutout portion 21 b and the protuberance 22a constitute a receiving portion in the circuit board 20. The electronic component 10 includes a pair of protrusions 16, which is fitted between the cutout portion 21 b and the protuberance 22a, a pair of first lugs 14, and a pair of second lugs 15. The first lugs 14 and the second lugs 15 contact the back side of the circuit board 20. With this configuration, fitting the protrusions 16 between the cutout portion 21 b and the protuberance 22a defines the position of the circuit board 20 in the planar direction on the electronic component 10. Also, causing the first lugs 14 and the second lugs 15 to contact the back side of the circuit board 20 defines the position of the circuit board 20 in the thickness direction in the electronic component 10. As a result, when the circuit board 20, on which the electronic component 10 is mounted, is arranged at a predetermined position in relation to the heat dissipater 30, the position of the connecting portion 13 is restrained from being displaced in relation to the boss portion 30a, to which the connecting member is connected.
(2) The positions at which the first lugs 14 and the second lugs 15 contact the back side of the circuit board 20 are located on the common plane. The first lugs 14 and the second lugs 15 are arranged in relation to the main body 11 such that a region Z surrounded by the lugs 14, 15 contains a part of the main body 11. Accordingly, when the first lugs 14 and the second lugs 15 contact the back side of the circuit board 20, the imaginary plane H of the region Z, which is surrounded by the lugs 14, 15, is parallel with the back side of the circuit board 20. Therefore, the orientation of the electronic component 10 is prevented from being inclined with respect to the back side of the circuit board 20.
(3) For example, when the second lugs 15 protrude in the direction in which the electrodes 12 protrude from the main body 11, the parts of the electrodes 12 that are inserted in the insertion holes 20h and the second lugs 15 need to be separated from each other by at least the insulation distance so that the insulation between the inserted parts and the second lugs 15 is ensured. Thus, the length of a part of each electrode 12 from the main body 11 to the insertion hole 20h needs to be extended by the insulation distance, which enlarges the overall size of the electronic component 10. Thus, the second lugs 15, which are provided at the end close to the electrodes 12 of the main body 11, each project in a direction perpendicular to the direction in which the electrodes 12 protrude. Compared to a case in which the second lugs 15 protrude from the main body 11 in the direction in which the electrodes 12 project, the above illustrated configuration shortens the length of a part of each electrode 12 from the main body 11 to the insertion hole 20h required to ensure a sufficient insulation distance between the part of each electrode 12 that is inserted in the corresponding insertion hole 20h and the corresponding second lug 15. This restrains the overall size of the electronic component 10 from being enlarged.
(4) Each electrode 12 is joined to the circuit board 20 by reflow soldering. The electrodes 12 are thus restrained from being moved by the surface tension of the solder 19 caused by reflow soldering.
(5) Since the position of the connecting portion 13 of the electronic component 10 is restrained from being displaced in relation to the boss portion 30a of the heat dissipater 30, the fastening of the connecting portion 13 to the boss portion 30a with the bolt 31 can be automated.

The above described embodiment may be modified as follows.

In the illustrated embodiment, the first lugs 14 may be omitted. In this case, on the edge of each long side plate portion 11 b opposite from the bottom plate portion 11 a, a part closer to the corresponding short side plate portion 11c functions as a contacting portion, which is allowed to contact the back side of the circuit board 20.

In the illustrated embodiment, although the number of contacting portions, which are allowed to contact the back side of the circuit board 20, is not particularly limited, the main body 11 preferably has three or more contacting portions.

In the illustrated embodiment, as long as the first lugs 14 and the second lugs 15 project in directions intersecting the direction in which the electrodes 12 protrude, the angles relative to the protruding direction of the electrodes 12 are not particularly limited.

In the illustrated embodiment, the first lugs 14 may protrude in the direction in which the extension 13a extends from the bottom plate portion 11a.

In the illustrated embodiment, the second lugs 15 may protrude in the direction in which the electrodes 12 protrude from the main body 11.

In the illustrated embodiment, the connecting portion 13 and the boss portion 30a may be connected, for example, by an adhesive.

In the illustrated embodiment, the electronic component 10 may be a chip that is surface-mounted on the circuit board 20.

In the illustrated embodiment, although the heat dissipater 30 is employed as a connecting member connected to the connecting portion 13, the connecting member is not particularly limited.

In the illustrated embodiment, the region Z may be a region that is surrounded by curves that connect substantially centers of parts of the first lugs 14 and the second lugs 15 that contact the back side of the circuit board 20.

In the illustrated embodiment, the region Z may be a region that is surrounded by straight lines or curves that connect edges of parts of the first lugs 14 and the second lugs 15 that contact the back side of the circuit board 20.

In the illustrated embodiment, the second circuit board 22 does not necessary need to be separated from the first circuit board when the connecting portion 13 is fastened to the boss portion 30a with the bolt 31. In this case, the second circuit board 22 needs to have a through-hole for receiving the bolt 31.

In the illustrated embodiment, the electrodes 12 may be joined to the circuit board 20 by a soldering method other than reflow soldering.

In the illustrated embodiment, the electrodes 12 may be joined to the circuit board 20 with an electrically conductive adhesive, which serves as a conductor.

## Claims

1. An electronic component comprising:
a main body; and
an electrode, which is provided on the main body and is configured to be joined to a circuit board with a conductor,
wherein the main body includes
a connecting portion, which is configured to be connected to a connecting member,
a fitting portion, which is allowed to be fitted to a receiving portion provided in the circuit board, and
a contacting portion, which is allowed to contact a surface of the circuit board.

2. The electronic component according to claim 1, wherein
in addition to the contacting portion, the main body includes two or more additional contacting portions,
positions at which the contacting portions contact the surface of the circuit board are located on a common plane, and
the contacting portions are arranged in relation to the main body such that a region surrounded by the contacting portions contains at least a part of the main body.

3. The electronic component according to claim 1, wherein
the electrode protrudes from the main body and is allowed to be inserted in an insertion hole provided in the circuit board, and
the contacting portion is located at an end of the main body that is close to the electrode, and the contacting portion protrudes in a direction intersecting a direction in which the electrode protrudes.

4. The electronic component according to claim 2, wherein
the electrode extends from the main body and is allowed to be inserted in an insertion hole provided in the circuit board,
at least one of the contacting portions is located at an end of the main body that is close to the electrode, and
the at least one of the contacting portions extends in a direction intersecting a direction in which the electrode extends.

5. The electronic component according to any one of claims 1 to 4, wherein the electrode is joined to the circuit board by reflow soldering.

6. The electronic component according to any one of claims 1 to 5, wherein the connecting member is a heat dissipater, which dissipates heat transferred from the circuit board.

7. The electronic component according to any one of claims 1 to 6, wherein the electronic component is a thermistor.
